# EUROPEAN PATENT APPLICATION

(11) **EP 4 672 316 A1**
(43) Date of publication of application: **31.12.2025**
(21) Application number: 24184252.5
(22) Date of filing: 25.06.2024
(51) Int. Cl.: H01L 23/14, H01L 23/373, H01L 23/495

(54) **A SUBSTRATE, IN PARTICULAR A LEAD-FRAME SUBSTRATE USED IN A SEMICONDUCTOR PACKAGE FOR MOUNTING A SEMICONDUCTOR DIE ELEMENT**

(71) Applicant: Nexperia B.V., 6534 AB Nijmegen (NL)
(72) Inventor: Dchar, Ilyas, Manchester (GB); Yandoc, Ricardo, Manchester, SK7 5BJ (GB)
(74) Representative: Pjanovic, Ilija

(57) **Abstract**

A substrate, in particular a lead-frame substrate used in a semiconductor package for mounting a semiconductor die element is proposed, wherein the substrate is composed of a layered configuration comprising at least: a first layer of a first material, comprising a first surface side a second surface side opposite to the first surface side, the first surface side arranged to receive a semiconductor die element; a second layer of a second material having a coefficient of thermal expansion, CTE, lower than the CTE of the first material of the first layer, comprising a first surface side and a second surface side opposite to the first surface side, the first surface side of the second layer arranged to be in contact with the second surface side of the first layer; a third layer of a third material having a CTE higher than the CTE of the second layer, comprising a first surface side and a second surface side opposite to the first surface side, the first surface side of the third layer arranged to be in contact with the second surface side of the second layer; and at least one via thermally connecting the first layer with the third layer.

## Description

### TECHNICAL FIELD

The present disclosure relates to a lead-frame substrate designed to provide the semiconductor die element with electronic connection to the environment and provide a path of thermal conduction.

### BACKGROUND OF THE DISCLOSURE

The present invention relates to a laminated lead-frame substrate used in a semiconductor package for mounting a semiconductor die element. A lead frame serves as a base for semiconductor chips, providing structural support and providing electrical connections to external circuitry. Due to the electrically conductive requirement of the lead-frame, it may typically be made of metal.

The operation of a semiconductor involves the generation of heat due to the flow of current. As electrons move through the semiconductor's lattice structure, they collide with atoms, transferring kinetic energy and generating heat. This heat leads to thermal expansion, causing the semiconductor material to expand. This semiconductor material typically reacts differently to heat than the lead-frame, as their coefficient of thermal expansion, CTE, typically lies lower than that of metal material of which the lead frame is formed. When two materials with different coefficients of thermal expansion are bonded or assembled together, their expansion or contraction rates may not match. This can lead to mechanical stress, deformation, or even failure at the interface between the materials, particularly when exposed to temperature variations during operation.

Therefore, a lead-frame substrate may be designed, which includes a central material cladded with a metal, typically copper, to better match the CTE of the semiconductor material.

However, a downside of this configuration may be that the thermal conductivity of the lead-frame may be significantly decreased, which leads to a lower thermal performance for the semiconductor package during operation.

Accordingly, it is a goal of the present disclosure to provide an improved configuration of the lead-frame substrate, which may provide an increased thermal performance, while keeping the lower CTE of the cladded lead-frame substrate design or keeping to the increased CTE match between the semiconductor die and the cladded lead-frame substrate.

### SUMMARY OF THE DISCLOSURE

It would be advantageous to propose a substrate, in particular a lead-frame substrate used in a semiconductor package for mounting a semiconductor die element, which allows for an increased thermal and electrical performance compared to conventional cladded-lead frame substrate designs. It would further be advantageous to achieve a method of manufacturing this substrate.

In the first aspect of the present disclosure, there is provided a substrate, in particular a lead-frame substrate used in a semiconductor package for mounting a semiconductor die element, wherein the substrate is composed of a layered configuration comprising at least:
- a first layer of a first material, comprising a first surface side a second surface side opposite to the first surface side, the first surface side arranged to receive a semiconductor die element
- a second layer of a second material having a coefficient of thermal expansion, CTE, lower than the CTE of the first material of the first layer, comprising a first surface side and a second surface side opposite to the first surface side, the first surface side of the second layer arranged to be in contact with the second surface side of the first layer;
- a third layer of a third material having a CTE higher than the CTE of the second layer, comprising a first surface side and a second surface side opposite to the first surface side, the first surface side of the third layer arranged to be in contact with the second surface side of the second layer;
   and
- at least one via thermally connecting the first layer with the third layer.

The layered configuration may comprise a first layer, comprising a high electrically and thermally conductive element, typically a metal, in particular copper. The at least three layers may further comprise a second layer, comprising an alloy or a metal, in particular molybdenum, a molybdenum-copper alloy or Invar, which is an iron-nickel alloy, wherein the alloy or the metal comprises a low thermal conductive layer. The second layer is included in order to provide a good CTE match with the semiconductor due element attached to the lead frame. This may be important as this may prevent strain between the lead-frame substrate and the attached semiconductor die. There may be included a third layer, comprising of a high electrical and thermally conductive material, typically, but not necessarily, the same material as the first layer. The first layer and the third layer may be cladded on the second layer and may provide a high electrical and thermal conductivity.

In another example there may be provided an additional set of layers, including a further second layer and a further third layer. The further second layer comprises a low thermal conductive layer. This further second layer may typically, but not necessarily, comprise of the same material as the second layer, providing a low thermal conductive layer and providing a good CTE match between the semiconductor substrate and the lead-frame substrate. The further third layer may comprise of a high electrical and thermally conductive element and may typically, but not necessarily, comprise of the same material as the third layer and/or the first layer.

The inventors have found that it may be beneficial to include at least one via in the substrate composed of the layered configuration, the at least one via may comprise an electrically and/or thermally conductive material, typically a solder also used to thermally, electrically and structurally connect the semiconductor die element to the lead-frame structure, or it may be a different conductive material, such as copper or a copper alloy. The at least one via may be used as a channel to allow an enhanced conduction of heat or charge by allowing the heat or charge to travel through the central layer of the substrate. This configuration may allow for an increased electrical and thermal performance of the whole package.

The layers of the layered configuration are connected or attached to each other by using roll-bonding methods. This is a cold-welding process where metal sheets are stacked, aligned and passed through rollers under a high pressure. This pressure causes the sheets to deform and bond together.

A via is defined as a filled hole, cavity or through-opening, which may provide a path for heat and/or charge to travel through the hole. The filling material may comprise a thermally conductive material, such as solder paste, comprising silver or copper sintering material, or any other type of die-attach solutions or electroplated metal, like copper.

The at least one via may be any shape, regular or irregular, and may be any size. Moreover, the number of vias is also not specified, meaning any number of vias will improve the performance of the package, so the present disclosure is not limited to any number of vias of any shape.

According to a first, of the disclosure, the at least one via connects the first layer to the third layer. The via then fully penetrates the second layer, composed of a material with a lower thermal conductivity than the first and/or third layer and it may partially penetrate the third layer.

In an example which may or may not comprise elements of the previous example, wherein the at least one via comprises long trenches, underlining the flexible nature of the via shape.

In a further example, two additional layers may be added to the lead-frame substrate, thereby defining a further second layer and a further third layer, the further second layer is composed a material with a lower thermal conductivity and CTE than the first and/or third layer and/or further third layer. The further third layer is composed of a material with a higher thermal conductivity and CTE than the second and/or further second layer.

The lead-frame substrate comprises vias, such that the heat may be conducted through the second layer and the further second layer.

The at least one via may be realized through laser drilling or punching processes among other drilling methods.

It should be noted that the at least one via is not limited to any regular spacing, or any regular size/shape and length. It may be possible that some of the at least one via may connect the first surface side of the first layer to a first surface side of the third layer, and simultaneously some of the at least one via may connect the second surface side of the first layer to the first surface side of the second layer, and some of the at least one via may connect the second surface side of the first layer to the second surface side of the third layer.

In another example, the end of the at least one via is in the body of a layer.

### BRIEF DESCRIPTION OF THE DRAWINGS

The disclosure will now be discussed with reference to the drawings, which show in:
Figure 1 a lead-frame substrate and an attached semiconductor die according to an example of the prior art;
Figure 2 the thermal conduction path of a lead-frame substrate and an attached semiconductor die of Figure 1;
Figure 3 a first example of a layered lead-frame substrate according to the disclosure;
Figure 4 a second example of a layered lead-frame substrate according to the disclosure;.
Figure 5 the thermal conduction path of the layered lead-frame substrate of Figure 4;
Figure 6 a third example of a layered lead-frame substrate according to the disclosure;
Figure 7 various further examples of a layered lead-frame substrate according to the disclosure implementing various suggestions of vias;
Figure 8 a fourth example of a layered lead-frame substrate according to the disclosure;
Figure 9 a fifth example of a layered lead-frame substrate according to the disclosure;
Figure 10 various further examples of a layered lead-frame substrate according to the disclosure implementing various suggestions of vias;
Figure 11 the method of manufacturing a layered lead-frame substrate according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

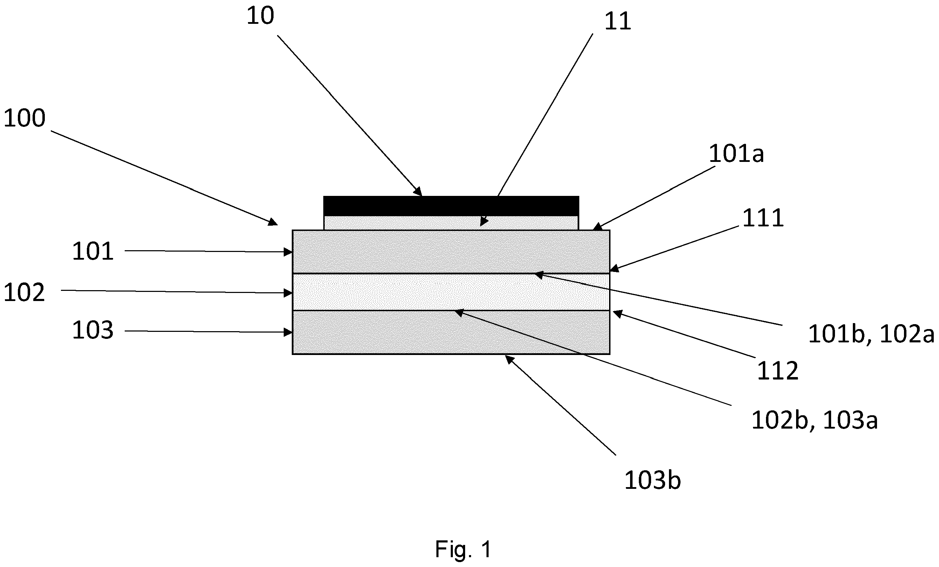

Figure 1 depicts an example of a lead-frame substrate 100 as disclosed in the prior art, having a layered configuration composed of at least three layers, indicated with reference numerals 101, 102, and 103. In particular, the first layer 101 is composed of a first material and comprises a first surface side 101a and a second surface side 101b opposite to the first surface side 101a. A second layer 102 composed of a second material is provided, having a first surface side 102a and a second surface side 102b opposite to the first surface side 102a, with the first surface side 102a of the second layer 102 arranged to be in contact with the second surface side 101b of the first layer 101, thereby forming a first transition layer 111.

The third layer 103 is composed of a third material and comprises a first surface side 103a and a second surface side 103b opposite to the first surface side 103a, with the first surface side 103a of the third layer 103 arranged to be in contact with the second surface side 102b of the second layer 102, thus forming a second transition layer 112.

As to the material characteristics, it is noted the second material of the second layer 102 has a coefficient of thermal expansion, CTE, which is lower than the CTE of the first material of the first layer 101. Similarly, the third material of the third layer 103 has a CTE higher than the CTE of the second layer 102.

A semiconductor die 10 is mounted or connected with solder paste 11 onto the first surface side 101a of the first layer 101 of the lead frame 100.

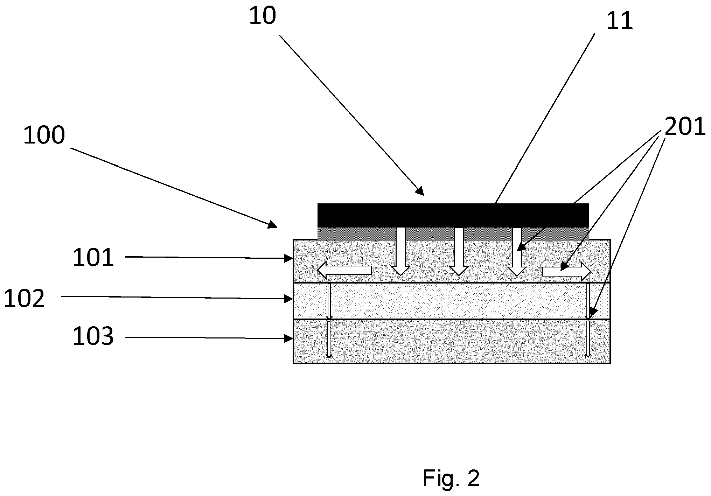

Figure 2 depicts the conduction of heat 201 through the lead-frame substrate 100 according to the prior art as shown in Figure 1, in which heat is generated during the operation of the semiconductor die 10. The majority of the generated heat is conducted through the first layer 101 through the lead frame 100, while only a small part of the heat being generated is able to be conducted through the layers 101-102-103 towards the second surface side 103b of the third layer 103, which is facing away from the heat generating semiconductor die 10, in a direction perpendicular to the surface sides of the layers 101-102-103. The limited amount of heat conducted towards the third layer 103 facing away from the heat generating semiconductor die 10 is due to the lower thermal conductivity of the second layer 102 having a material with a low thermal conductivity compared to the thermal conductivity of either first layer 101 and/or third layer 103.

As outlined in the introduction, when two materials with different CTE are bonded or assembled, their expansion or contraction rates may not match. This can lead to mechanical stress, deformation, or even failure along the interface between the materials, particularly when exposed to temperature variations during operation. Accordingly, lead-frame substrate configurations have be designed, which includes a layered configuration of a central material cladded with an outer metal, typically copper, with the outer metal better matching the CTE of the semiconductor die material mounted thereon.

However, a downside of this layered configuration may be that the thermal conductivity of heat through the lead-frame may be significantly decreased, due to the central material typically, along with the lower CTE, also having a low thermal conductivity, which subsequently leads to a lower thermal performance for the semiconductor package.

Accordingly, it is a goal of the present disclosure to provide an improved configuration of the lead-frame substrate, which may provide increased thermal and electrical performances, while keeping to the increased CTE match of the cladded lead-frame substrate design.

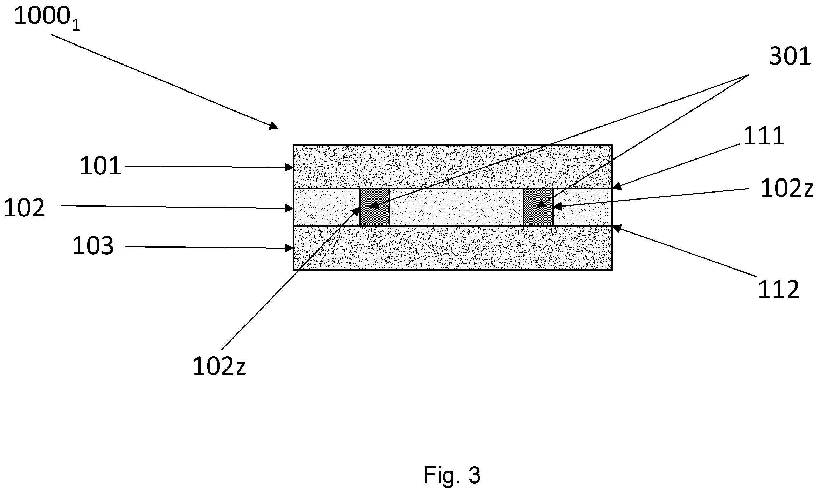

According to a first example of the disclosure, Figure 3 depicts a layered lead frame 1000, with two vias indicated with reference numeral 301 accommodated in the, intermediate, second layer 102 and thermally interconnecting the first layer 101 and the third layer 103. Note, that at least one via 301 may be utilized in order to provide at least one heat conduction channel that is able to conduct heat from the first layer 101, having the higher thermal conductivity, across the second layer 102, having the lower thermal conductivity, towards the third layer 103. Thus, one via 301 would suffice, whereas multiple vias 301 (two, three, four or more) may further enhance thermal interconnection and conductivity between the first layer 101 and the third layer 103.

In Figure 3, the vias 301 are accommodated in corresponding through openings 102z in the second layer 102 forming at least a thermal connection between the first transition 111 between the first layer 101 and the second layer 102 and the second transition 112 between the second layer and the third layer 103, respectively. In the example of Figure 3 the length of the vias 301 is identical as the thickness of the second layer 102, and thermally and physically connect with both the first layer 101 and the third layer 103 at the respective transitions 111 and 112.

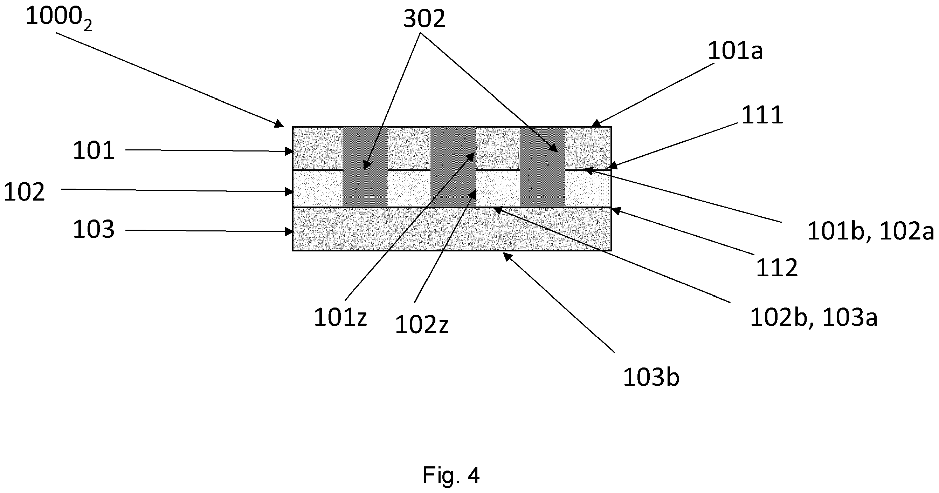

Figure 4 depicts another example of a layered lead-frame substrate according to the disclosure, the lead-frame substrate being denoted with reference numeral 1000₂. In this example, the at least one via 302 extends from the first surface side of the first layer 101, through the first layer 101, across the first transition layer 111, through the second layer 102 to the first surface side 103a of the third layer 103 at the second transition layer 112. This allows for an at least relatively simple way to create the at least one via by creating an aligned through-opening 101z-102z in both the first layer 101 and the second layer 102. A solder paste, which has a higher thermal conductivity than that of the second material of the second layer 102, may be used to fill the aligned through-opening 101z-102z, thus forming the via 302 and thereby creating the thermal connection between the first layer 101 and the third layer 103.

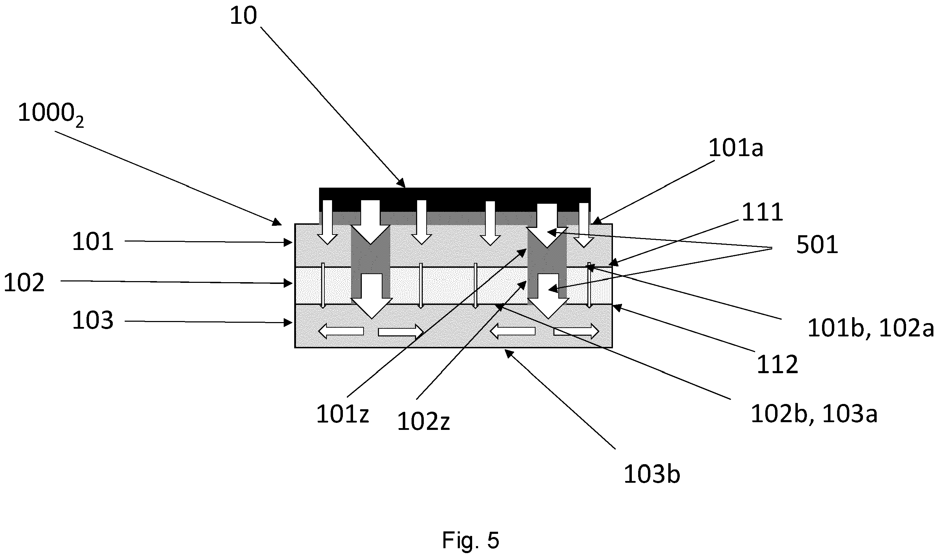

In Figure 5 the heat conduction of the example of the lead-frame substrate 1000₂ as depicted Figure 4 comprising the at least one via 302 is depicted. Herein the heat conduction channels thus created by the vias 302 allow for an efficient conduction 501 of the heat generated by the semiconductor die 10 (not shown in Figure 4) between the first layer 101 and the third layer 103. In this example of the present configuration, the advantages of the good CTE match between the semiconductor die 10 and the lead-frame substrate 1000₂ remain, while allowing for an increased heat conduction, enhancing the thermal performance of the semiconductor package.

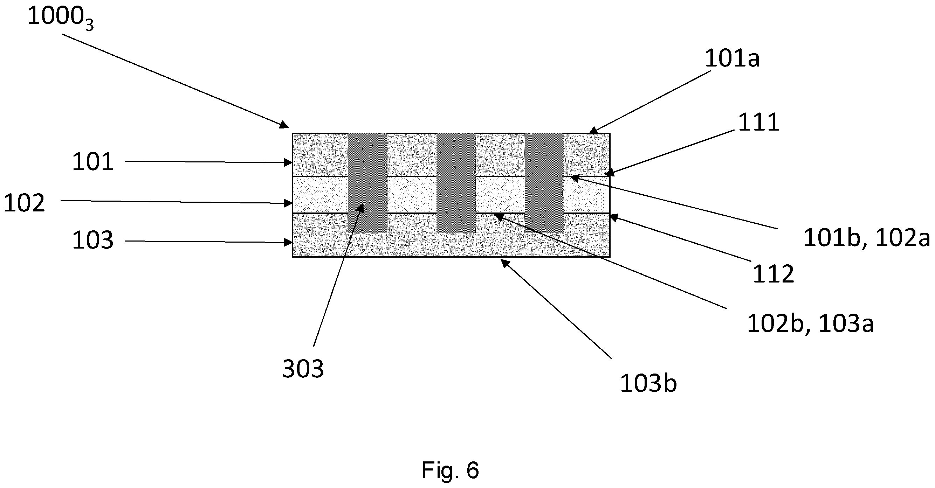

In Figure 6 a further example of a layered lead frame 1000₃ is shown, wherein the one or more vias 303 extend from the first surface side 101a of the first layer 101, through the first layer 101, across the first transition layer 111, through the second layer 102, past the second transition layer 112 and into the third layer 103. In this example the length (or depth) of the via 303 is at least equal to the combined thickness of the first layer 101, the second layer 102 and part of the third layer 103. The advantages of including the at least one via 303 is kept, while lowering the constraint on the manufacturing process. This example is not limited to any penetration depth of the via 303 into the third layer 103 as long as the via 303 does not reach the second surface side 103b of the third layer 103.

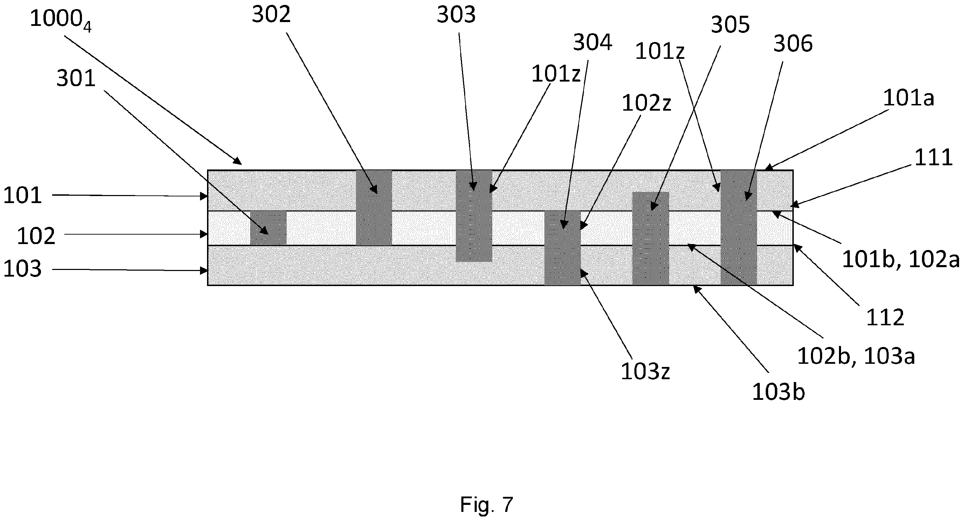

In Figure 7 further combined examples of a lead frame 1000₄ according to the disclosure are shown, implementing various configurations of vias, denoted with 301 (first example of Figure 3), 302 (second example of Figure 4), and 303 (third example of Figure 6). Here an additional example of a via according to the disclosure is denoted with numeral 304. Via 304 has a mirrored configuration of via 302 as it extends from the second surface side 103b of the third layer 103, through the third layer 103, across the second transition layer 112 and through the second, intermediate layer 102 towards the second surface side 101b of the first layer 101, at the position of the first transition layer 111. Hereby a thermally and/or electrically connection between the first layer 101 with the third layer 103 is likewise achieved. A further example of a via according to the disclosure is denoted with numeral 305, having a mirrored configuration of the via 303, wherein the end face of the at least one via 305 extends through the second layer 102, past the first transition layer 111 and into the first layer 101. This example is not limited to any penetration depth of the via 305 into the first layer 101 as long as the via 305 does not reach the first surface side 101a of the first layer 101.

Further, an example of another via according to the disclosure is denoted with numeral 306, wherein the at least one via 306 extends fully through the layered configuration. The vias 301 through 306, are not limited to any size, shape and length, but are also not limited by their regularity, a via may also comprise of an irregular shape. The vias may also comprise any through-opening shape, such as a tapered through-opening or a taper-less through-opening. The vias in a single semiconductor package are not limited to any regular spacing or are not required to comprise of the same single via shape, though it is preferred to be a regular shape, which can easily be manufactured.

The vias 302, 303, 304, 305, and 306 can be created by suitable through openings 101z-102z-103z which are applied in an aligned manner in the various first, second and third layers 101-102-103. A solder paste, which has a higher thermal conductivity than that of the second material of the second layer 102, may be used to fill the aligned through-opening 101z-102z-103z, thus forming the various vias 302-306 and thereby creating the thermal connection between the first layer 101 and the third layer 103.

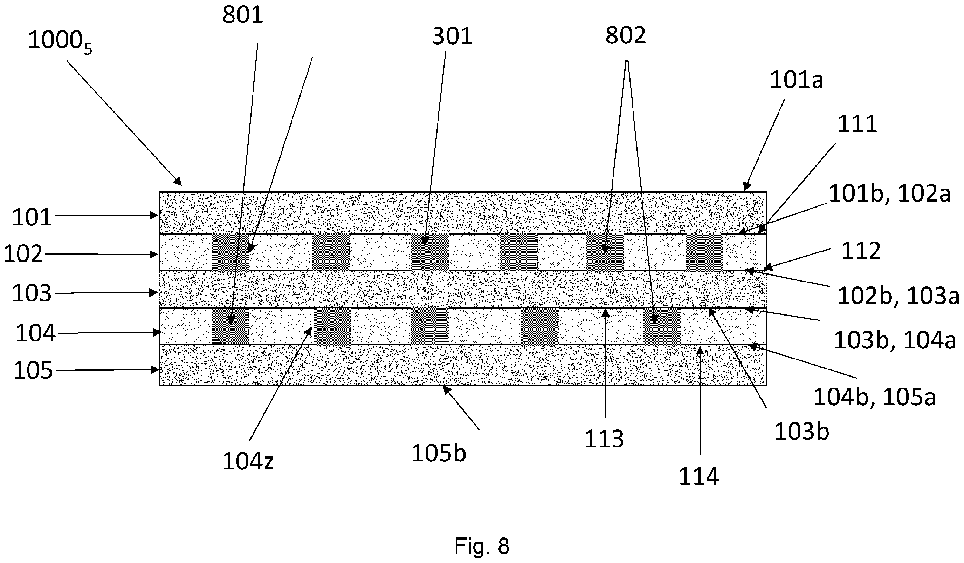

Figure 8 depicts an example of a lead-frame substrate 1000s according to the disclosure, wherein a set composed of a furthest second layer 104 and a further third layer 105 is arranged to be attached or mounted to the third layer 103. In particular, the further second layer 104 is added, and is composed of a fourth material and comprises a first surface side 104a and a second surface side 104b opposite to the first surface side 104a. The first surface side 104a of the further second layer 104 is arranged to be in contact with the second surface side 103b of the third layer 101, thereby forming a third transition layer 113. Further, the further third layer 105 composed of a fifth material is provided, having a first surface side 105a and a second surface side 105b opposite to the first surface side 105a, with the first surface side 105a of the further third layer 105 arranged to be in contact with the second surface side 104b of the further second layer 104, thereby forming a fourth transition layer 114.

In this example, at least one additional via 301, through the further second layer 104, is added in order to thermally connect the first layer 101 to the further third layer 105. The at least one additional via 301 of the further second layer 105 may be provided as a via 801, which is aligned with the via 301 in the second layer 102. Alternatively, the additional via 301 of the further second layer 105 may be provided as a via 802 which is out of alignment with a corresponding via 802 of the second layer 102.

As to the material characteristics, it is noted the fourth material of the further second layer 104 has a CTE which is lower than the CTE of the first and third material of the first and third layer 101-103. Similarly, the fifth material of the further third layer 105 has a CTE higher than the CTE of the second and further second layer 102-104. Furthermore, it is noted the fourth material of the further second layer 104 has a thermal conductivity which is lower than the thermal conductivity of the first and third material of the first and third layer 101-103. Similarly, the fifth material of the further third layer 105 has a thermal conductivity higher than the thermal conductivity of the second and further second layer 102-104.

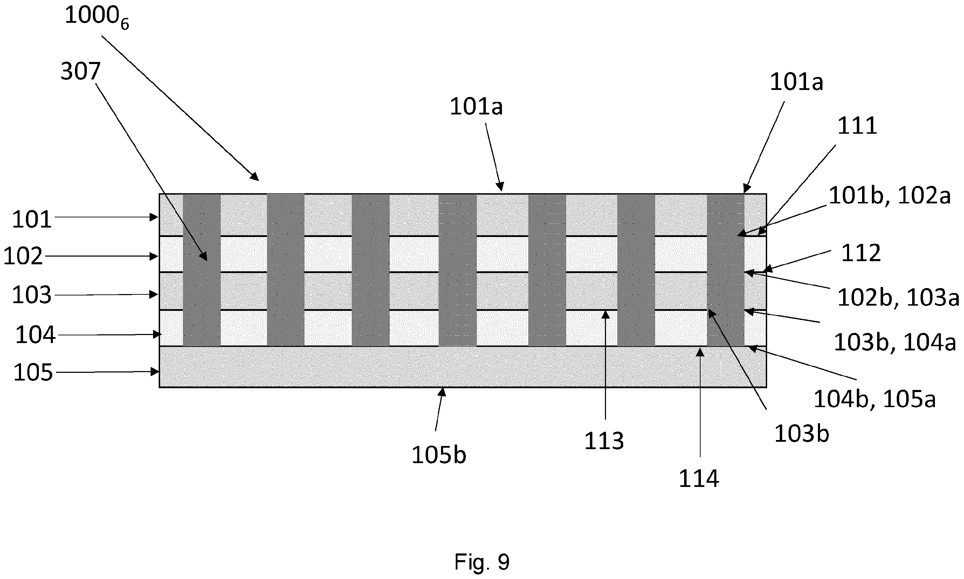

In Figure 9 a further example of the lead-frame 1000s according to the disclosure is depicted, comprising the layer configuration of Figure 8 having the layers 101-105. Here an example of a via according to the disclosure is denoted with numeral 307 and extends from the first surface side 101a of the first layer 101 to the first surface side 105a of the further third layer 105. The via 307 is formed of aligned through openings 101z-102z-103z-104z provide in the various first, second, third and fourth layers 101-104. A solder paste, which has a higher thermal conductivity than that of the second material of the second layer 102 and the further second layer 104, may be used to fill the aligned through-opening 101z-102z-103z-104z, thus forming the vias 307.

The at least one via 307 comprises at least two vias with a first via arranged through the second layer, extending from its first surface side towards its second surface side, and a second via arranged through the further second layer, extending from its first surface side towards its second surface side.

The at least one via 307 is arranged to thermally and/or electrically connect the first layer 101, via the third layer 103 with the further third layer 105. In this example, every of the at least one via 307 extends through both the first layer 101, the second layer 102, the third layer 103 and the further second layer 104, past the various first, second and third transition layers 111-112-113. The at least one via 307 may be connected to the first surface side 101a of the first layer 101 and the first surface side 105a of the further third layer 105. In this example the length (or depth) of the via 307 is at least equal to the combined thickness of the first layer 101, the second layer 102, the third layer 103 and the further second layer 104.

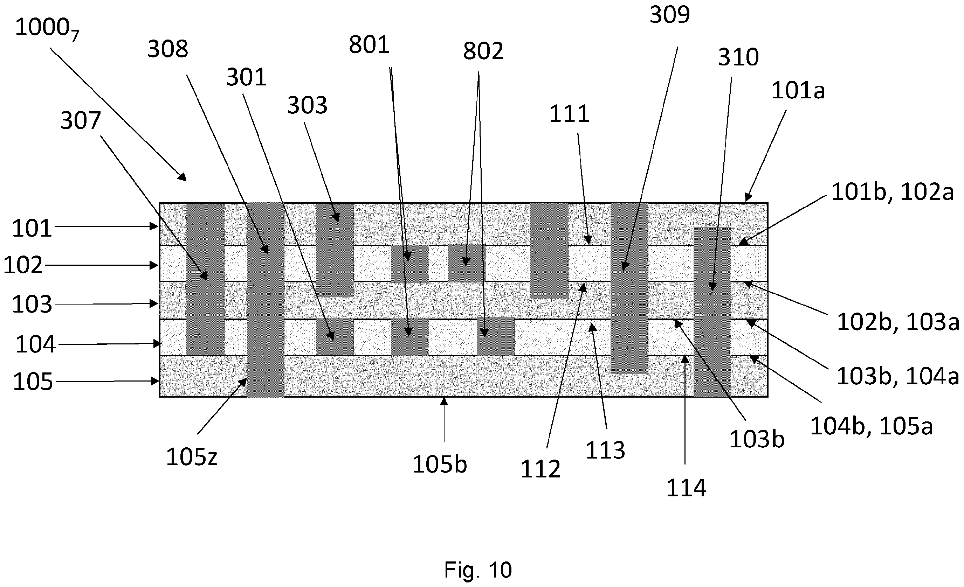

In Figure 10 further combined examples of a lead-frame substrate 1000₇ according to the disclosure are shown, implementing various configurations of vias. Here, via 306 (as depicted in Figure 7) may be extended to penetrate the further second layer 104 and the further third layer 105 ending at its second surface side 105b, this via according to the disclosure being denoted with numeral 308. Via 308 is provided in an aligned through opening 101z-102z-103z-104z-105z completely extending through the thickness of the layered lead frame 1000₇. A further example of vias may be based on the configuration of any of the vias 301-303 of Figure 7 and have an additional via 801 (aligned version) or 802 (not aligned version). This additional via might correspond to any of the vias 301-303. A further example of a via according to the disclosure is denoted by the numeral 309, wherein the at least one via 309 is arranged through the first layer 101, extending from the first surface side 101a of the first layer 101, through the second layer 102, the third layer 103 and the further second layer 104 towards at least the second surface side 104b of the further second layer, past its first surface side 105a, past the fourth transition layer 114. In this example the length (or depth) of the via 309 is at least equal to the combined thickness of the first layer 101, the second layer 102, the third layer 103, the further second layer 104 and part of the further third layer 105. The advantages of including the at least one via are maintained, while lowering the constraint on the manufacturing process, this example is not limited to any penetration depth of the via 309 into the further third layer 105 as long as the via 309 does not reach the second surface side 105b of the further third layer 105.

Similar to Figure 7, a further example of a via, herein denoted by the reference numeral 310 may also extend from the second surface side 105b of the further third layer 105, through the further second layer 104, through the third layer 103, and extending at least to the first surface side 101b of the first layer 101, similar to the mirrored via 307, but it may also extend past the first surface side 101b of the first layer 101 into the first layer 101, similar to the mirrored via 309.

As mentioned before, the at least one via is not limited to any regular spacing or are not required to comprise of the same single via shape, though it is preferred to be a regular shape and having regular spacing, which allows for ease of manufacturability.

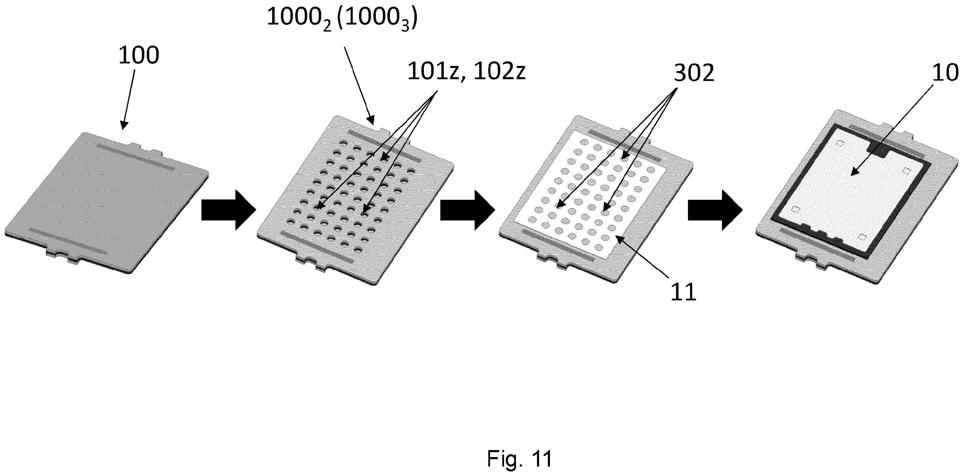

Figure 11 shows the assembly of the lead-frame substrate, wherein the method of manufacturing is as follows: First a lead-frame substrate 100 as disclosed in the prior art with at least three layers is provided. Subsequently, through-openings 101z, 102z are drilled using appropriate methods, such as laser drilling or punching, among others, leaving a layered lead-frame substrate 1000 comprising through-openings 101z and 102z. After this, a solder paste is added, filling the through-openings, thereby creating the at least one via 302 and providing the solder paste 11 used to attach the semiconductor die 10, which is connected in a last step.

The present disclosure further discloses a method of manufacturing the substrate having a layered configuration according to the present disclosure, wherein the method comprises the steps of:
a-i) providing the substrate comprising at least the first layer, the second layer and the third layer;
a-ii) providing one or more through-openings through the first layer or the third layer and through the second layer;
a-iii) filling the one or more through-openings with a metal material, thereby creating at least one via thermally connecting the first layer with the third layer.

The present disclosure further discloses a further method of manufacturing the substrate having a layered configuration according to the present disclosure, wherein the method comprises the steps of:
b-i) providing the second layer;
b-ii) providing one or more through-openings through the second layer;
b-iii) filling the one or more through-openings with a metal material;
b-iv) providing the first layer and the third layer on either side of the second layer, thereby forming the substrate having a layered configuration with at least one via thermally connecting the first layer with the third layer.

The further method of manufacturing the substrate, wherein step b-ii) may further comprise the step of drilling or punching the one or more through openings.

The method of manufacturing the substrate, wherein step b-iii) may further comprise the step of filling the one or more through-openings through metal plating or may further comprise the step of plugging the one or more through-openings with a metal plug.

The method of manufacturing the substrate, further comprising, after step b-iii) but prior to step b-iv) the step of polishing both surface sides of the second layer; and
wherein the step b-iv) comprises the step of roll binding the first layer and the third layer on either side of the second layer.

The present disclosure may be integrated in a semiconductor package, comprising the lead-frame substrate according to the disclosure, wherein a semiconductor die is mounted on the first surface side of the first layer of the substrate and whereby the semiconductor die is fully encapsulated, and the substrate is partially encapsulated by an encapsulant.

In a different example of the present disclosure, the at least one via is not perpendicular to the first surface side 101a of the first layer 101 but instead has a non-90-degree angle. This example still reaches the desired effect of connecting the first layer 101 with the third/further third layer 103-105.

In a different example, there may be additional layers added to the lead-frame substrate such that the desired good CTE match is kept.

In a different example, the manufacturing process may be different, the creation of the at least one via may occur prior to the rolling steps, which are used to create the lead-frame substrate comprising at least three layers as disclosed in the prior art.

In a different example, the at least one through-opening may instead be filled with a different thermally conductive material, or other electroplated metals such as copper or a copper alloy. Following the creation of this at least one via may be the addition of solder paste, whereon the semiconductor die is attached, this configuration reaches the desired effect of creating a thermal conduction channel within a lead-frame substrate.

In the present disclosure, the first or second surface side of a layer are arranged on opposite sides of the layer, wherein the layer also comprises a body, comprising a layer material. The surface sides of a layer are arranged at least substantially parallel to each other. The length of the surface sides is preferably larger than the thickness of a single layer. In the present disclosure, a surface side may be a surface of a layer.

In the present disclosure, the at least one via may comprise of any number of vias, for example 30 vias with a diameter of 0.5 mm or it may comprise of for example 52 vias.

In the present disclosure, the at least one vias may be arranged at least substantially parallel to each other.

In the present disclosure, the at least one via may comprise a circular, a triangular, a rectangular or any other cross-sectional shape.

In the present disclosure, the material with the low CTE, may have a CTE of lower than 10 ppm/°C and the material with the high CTE may have a CTE of higher than 15 ppm/°C. Furthermore, the material with a low thermal conductivity may have a thermal conductivity of lower than 44 W/mK and the material with a high thermal conductivity may have a thermal conductivity of higher than 150 W/mK.

### LIST OF REFERENCE NUMERALS USED

- 10: semiconductor die
- 11: solder paste
- 100: lead-frame substrate as disclosed in the prior art
- 101: first layer
- 101a: first surface side of the first layer
- 101b: second surface side of the first layer
- 101z: through-opening in the first layer
- 102: second layer
- 102a: first surface side of the second layer
- 102b: second surface side of the second layer
- 102z: through-opening in the second layer
- 103: third layer
- 103a: first surface side of the third layer
- 103b: second surface side of the third layer
- 103z: through-opening in the third layer
- 104: further second layer
- 104a: first surface side of the further second layer
- 104b: second surface side of the further second layer
- 104z: through-opening in the further second layer
- 105: further third layer
- 105a: first surface side of the further third layer
- 105b: second surface side of the further third layer
- 105z: through-opening in the further third layer
- 111-114: transition layer (1^{st} - 4^{th})
- 201: thermal conduction paths
- 301-310: via (1^{st} - 10^{th} example)
- 501: thermal conduction path
- 801: aligned vias
- 802: unaligned vias
- 1000ₙ: a lead-frame substrate according to the disclosure (1^{st} - 7^{th} example)

## Claims

1. A substrate, in particular a lead-frame substrate used in a semiconductor package for mounting a semiconductor die element, wherein the substrate is composed of a layered configuration comprising at least:
- a first layer of a first material, comprising a first surface side a second surface side opposite to the first surface side, the first surface side arranged to receive a semiconductor die element;
- a second layer of a second material having a coefficient of thermal expansion, CTE, lower than the CTE of the first material of the first layer, comprising a first surface side and a second surface side opposite to the first surface side, the first surface side of the second layer arranged to be in contact with the second surface side of the first layer;
- a third layer of a third material having a CTE higher than the CTE of the second layer, comprising a first surface side and a second surface side opposite to the first surface side, the first surface side of the third layer arranged to be in contact with the second surface side of the second layer;
and
at least one via thermally connecting the first layer with the third layer.

2. The substrate according to claim 1, wherein the at least one via is arranged through the second layer, extending from the first surface side of the second layer towards the second surface side of the second layer.

3. The substrate according to claim 2, wherein the at least one via is arranged in the first layer, extending from the first surface side of the first layer, through the second layer towards at least the first surface side of the third layer.

4. The substrate according to claim 3, wherein the at least one via extends into the third layer past its first surface side.

5. The substrate according to claim 2, wherein the at least one via is arranged in the third layer, extending from the second surface side of the third layer, through the second layer towards at least the second surface side of the first layer.

6. The substrate according to claim 5, wherein the at least one via extends into the first layer past its second surface side.

7. The substrate according to any of the previous claims, further comprising at least one set of a further second layer and a further third layer, wherein
- the further second layer consists of a fourth material having a CTE lower than the CTE of the first material and the third material, comprising a first surface side and a second surface side opposite to the first surface side, the first surface side arranged to be in contact with the second surface side of the third layer; and wherein
- the further third layer consists of a fifth material having a CTE higher than the CTE of the second layer and the further second layer, comprising a first surface side and a second surface side opposite to the first surface side, the first surface side arranged to be in contact with the second surface side of the further second layer; and wherein
- the at least one via thermally connects the first layer with the third layer and the further third layer.

8. The substrate according to any of the previous claims, wherein the fourth and/or second material is selected from the group: invar, molybdenum or a molybdenum-copper alloy.

9. The substrate according to any of the previous claims, wherein the fifth, and/or the third and first material comprise a material with a high thermal conductivity, in particular copper or a copper alloy.

10. A method of manufacturing the substrate having a layered configuration according to any of the previous claims, wherein the method comprises the steps of:
a-i) providing the substrate comprising at least the first layer, the second layer and the third layer;
a-ii) providing one or more through-openings through the first layer or the third layer and through the second layer;
a-iii) filling the one or more through-openings with a metal material, thereby creating at least one via thermally connecting the first layer with the third layer.

11. A method of manufacturing the substrate having a layered configuration according to any of the claims 1-9, wherein the method comprises the steps of:
b-i) providing the second layer;
b-ii) providing one or more through-openings through the second layer;
b-iii) filling the one or more through-openings with a metal material;
b-iv) providing the first layer and the third layer on either side of the second layer, thereby forming the substrate having a layered configuration with at least one via thermally connecting the first layer with the third layer.

12. The method of manufacturing the substrate according to claim 11, wherein step b-ii) comprises the step of drilling or punching the one or more through openings.

13. The method of manufacturing the substrate according to claim 11 or 20, wherein step b-iii) comprises the step of filling the one or more through-openings through metal plating or comprises the step of plugging the one or more through-openings with a metal plug.

14. The method of manufacturing the substrate according to any one or more of the claims 11-13, further comprising, after step b-iii) but prior to step b-iv) the step of polishing both surface sides of the second layer; and/or
wherein the step b-iv) comprises the step of roll binding the first layer and the third layer on either side of the second layer.

15. An semiconductor package, comprising the substrate according to any of the claims 1-14, wherein a semiconductor die is mounted on the first surface side of the first layer of the substrate and whereby the semiconductor die is fully encapsulated, and the substrate is partially encapsulated by an encapsulant.
